# EUROPEAN PATENT APPLICATION

(11) **EP 1 357 419 A1**
(43) Date of publication of application: **29.10.2003**
(21) Application number: 02710477.7
(22) Date of filing: 01.02.2002
(51) Int. Cl.: G02F 1/13, G03B 27/32, G03F 7/20

(54) **LIQUID CRYSTAL SHUTTER FOR EXPOSURE SYSTEM**

(30) Priority: 02.02.2001 JP 2001026286; 10.07.2001 JP 2001209673
(71) Applicant: Citizen Watch Co. Ltd., Tokyo 188-8511 (JP)
(72) Inventor: MATSUNAGA, Masaaki C/O CITIZEN WATCH CO., LTD., Nishitokyo-shi, Tokyo 188-8511 (JP); SHIOTA, Akira C/O CITIZEN WATCH CO., LTD., Nishitokyo-shi, Tokyo 188-8511 (JP); HOSHINO, Koichi C/O CITIZEN WATCH CO., LTD., Nishitokyo-shi, Tokyo 188-8511 (JP)
(74) Representative: Patentanwälte Ruff, Wilhelm, Beier, Dauster & Partner
(86) International application number: JP0200857
(87) International publication number: WO02063382

(57) **Abstract**

A liquid crystal shutter wherein three shutter rows corresponding to red, green and blue, respectively, are formed on a single liquid crystal shutter substrate. Each shutter row is configured of the liquid crystal held between at least one transparent substrate formed with a common electrode and another transparent substrate formed with cell electrodes corresponding to the cell rows of each of the two shutter rows, arranged in staggered fashion, and lead electrodes. The relation Q = NP holds, where Q is the pitch of the shutter rows, P the pitch of the two cell rows, and N a positive integer larger than 2.

## Description

### TECHNICAL FIELD

The present invention relates to a liquid crystal shutter for an exposure device and, in particular to a liquid crystal shutter built into an exposure device for controlling the exposure of a photosensitive medium such as photographic paper by controlling the interruption and transmission of light from a light source.

### BACKGROUND ART

As a conventional exposure device for recording an image on a photosensitive medium, an exposure device, or an optical printer, is known which forms a latent image or a color image on a photosensitive medium by controlling the amount of the light transmitted from a light-emitting diode, or the like, light source using a liquid crystal shutter. In these devices, generally, three types of light for the primary colors, red (R), green (G) and blue (B), are radiated from a light source toward a photosensitive medium and, while a liquid crystal shutter is arranged in the light paths of these light rays, the photosensitive medium is moved relatively to the liquid crystal shutter at a position proximate to the liquid crystal shutter, each cell (pixel) of the liquid crystal shutter is opened or closed in accordance with the image data in synchronism with the movement of the photosensitive medium and, by thus controlling the transmitted light amount of the light of each of the three primary colors, the photosensitive medium is appropriately exposed to the light.

An example of the conventional optical printer is described in Japanese Unexamined Patent Publication No. 2-227268 (US Patent Serial No. 5,105,281). This patent publication discloses a configuration in which the light emitted from a single light source is used to expose the same part of a photosensitive medium three times by means of three rows of liquid crystal shutters for the three primary colors arranged in an overlapped relation with the three color filters of red, green and blue, respectively, and each of the three rows of the liquid crystal shutters for the three colors is formed of two rows of liquid crystal shutters arranged in an optically staggered fashion (hereinafter referred to simply as "in a staggered fashion"). According to an embodiment of the invention disclosed in the aforementioned patent publication, a configuration is disclosed in which each liquid crystal shutter is an active shutter turned on and off by a switching transistor, and the liquid crystal shutters for the respective colors are each arranged in two staggered rows at the same pitch P in a total of six rows along the direction in which the film is fed at the same pitch P. The film is moved five times at the feed pitch P, so that the images of the shutters are superposed for exposure by additive color mixture at the film position.

Specifically, Japanese Unexamined Patent Publication No. 2-227268 discloses a configuration in which a plurality of shutters arranged in two staggered rows for each color are arranged closely in three rows in such a manner as to hold the relation Q = 2P, where P is the pitch of the liquid crystal shutters for the same color and Q the pitch between the shutter row of a given color and an adjacent shutter row of another color.

The conventional technique described in the aforementioned patent publication, however, poses the problem that, in the case where the three rows of the shutters are irradiated with light at the same time, the light fluxes interfere with adjacent shutter rows for lack of the gap (Q = 2P) between the shutter rows of adjacent colors.

A possible solution to this problem is to increase the value Q by forming a space between the shutter rows for the respective colors. An increased value Q, however, poses a new problem that the substrates of the liquid crystal shutter are increased in size, so that in the case where passive liquid crystal cells are used for the liquid crystal shutter, the upper and lower transparent substrates are warped and the shutter characteristics are deteriorated.

The problem of the warping of the upper and lower transparent substrates may be solved by scattering spacers between the upper and lower substrates. The employment of this method, however, harbors the problem that the superior optical characteristics required of the. liquid crystal shutter, as compared with the ordinary liquid crystal cells, are deteriorated due to the presence of the spacers in the cells.

Further, in the case where passive liquid crystal cells arranged in staggered fashion make up three rows of liquid crystal shutters, the lead electrodes to the cells are so arranged that the lead electrodes for the two shutter rows on the sides are led out to the two sides of the substrate, while the lead electrodes for the central shutter row are led to the two sides of the substrate through the spaces between the cells making up the left and right shutter rows (see Japanese unexamined Patent Publication No. 6-186581 for a description of this method of laying the lead wires). This method involves the problem that the shutter operation is hampered by the interference between the shutter rows due to the electric field generated between the lead electrodes of the central shutter row and each of the cell electrodes and the common electrode making up the left and right shutter rows.

### DISCLOSURE OF THE INVENTION

Accordingly, an object of this invention is to provide a liquid crystal shutter for the exposure device, wherein the shutter rows of the three colors are arranged in spaced relation with each other to avoid the interference of the light fluxes with adjacent shutter rows, so that even in the case where a passive liquid crystal is used for the liquid crystal shutter, the upper and lower transparent substrates are not warped while at the same time preventing the deterioration of the optical characteristics of the shutter.

Another object of the invention is to provide a liquid crystal shutter for the exposure device, comprising three shutter rows each including a plurality of passive liquid crystal cells arranged in staggered fashion, wherein the shutter operation is not hampered by the interference which otherwise might caused by the electric field generated between the lead electrodes of the central shutter row and the cell electrodes the common electrode of the left and right shutter rows.

In order to achieve the objects described above, according to a first aspect of the invention, there is provided a liquid crystal shutter, wherein a plurality of exposure cells are formed as a plurality of shutter rows on a transparent substrate and built in the exposure device for controlling the exposure of the photosensitive medium, characterized in that each shutter row includes a plurality of cells arranged in two optically staggered (hereinafter referred to only as "staggered") rows in such a manner as to hold the relation Q = NP, where Q is the pitch of the shutter rows, P the pitch of the two cell rows and N a positive integer larger than 2.

According to a second aspect of the invention, there is provided a liquid crystal shutter for the exposure device in the aforementioned first aspect, comprising a transparent common electrode and transparent cell electrodes formed on two transparent substrates, respectively, with the liquid crystal held therebetween, and a plurality of lead electrodes for leading out the transparent cell electrodes.

According to a third aspect of the invention, there is provided a liquid crystal shutter for the exposure device in the aforementioned first aspect, characterized in that a plurality of the shutter rows are three shutter rows corresponding to red, green and blue, the lead electrodes connected to the transparent cell electrodes of the shutter rows on the two sides are led out toward the ends of the transparent substrate, the lead electrodes connected to the transparent cell electrodes of the central shutter row are divided into two groups, one led out toward one end and the other led out toward the other end of the transparent substrate.

According to a fourth aspect of the invention, there is provided a liquid crystal shutter for the exposure device in the aforementioned third aspect, characterized in that the lead electrodes connected to the transparent cell electrodes of the central shutter row are led out through the spaces between the electrodes of the transparent cell electrodes of the two shutter rows on the two sides, respectively.

According to a fifth aspect of the invention, there is provided a liquid crystal shutter for the exposure device in the aforementioned second aspect, characterized in that a partitioning wall for defining the interval of the two transparent substrates is arranged between each adjoining ones of a plurality of shutter rows,

According to a sixth aspect of the invention, there is provided a liquid crystal shutter for the exposure device in the aforementioned fifth aspect, characterized in that the pitch Q of the shutter rows is set longer than the distance equal to the sum of the width of the partitioning wall and twice the width of the fringe formed by the partitioning wall.

According to a seventh aspect of the invention, there is provided a liquid crystal shutter for the exposure device in the aforementioned sixth aspect, characterized in that the width of the fringe is not less than 2 mm.

According to an eighth aspect of the invention, there is provided a liquid crystal shutter for the exposure device in the aforementioned first aspect, characterized in that a plurality of cells are each so configured that the liquid crystal is held between a single transparent common substrate formed with transparent cell electrode and a lead electrode for leading out the transparent cell electrode on the one hand and a plurality of opposed transparent substrates formed with the transparent common electrodes corresponding to the respective shutter rows on the other hand.

According to a ninth aspect of the invention, there is provided a liquid crystal shutter for the exposure device in the aforementioned eighth aspect, characterized in that a plurality of the shutter rows are three shutter rows corresponding to red, green and blue, respectively, and a plurality of the opposed transparent substrates formed with the transparent common electrodes are three opposed transparent substrates corresponding to the three shutter rows, respectively.

According to a tenth aspect of the invention, there is provided a liquid crystal shutter for the exposure device in the aforementioned eighth aspect, characterized in that a plurality of the shutter rows are three shutter rows corresponding to red, green and blue, respectively, and a plurality of the opposed transparent substrates formed with the transparent common electrodes are two opposed transparent substrates including one transparent substrate corresponding to two adjacent ones of the three shutter rows and another transparent substrate corresponding to the other one shutter row.

According to an 11th aspect of the invention, there is provided a liquid crystal shutter for the exposure device in any of the aforementioned eighth to tenth aspects, characterized in that the liquid crystal held between a plurality of the opposed transparent substrates and the transparent common substrate is sealed by a seal member for each of the opposed transparent substrates.

According to a 12th aspect of the invention, there is provided a liquid crystal shutter for the exposure device in the aforementioned first aspect, characterized in that the value N is 46,

With the liquid crystal shutter for the exposure device according to this invention, the shutter rows of the respective colors are arranged in spaced relation with each other to prevent the light fluxes from interfering with adjacent shutter rows, and the upper and lower transparent substrates are not warped nor the optical characteristics of the shutter deteriorated even in the case where passive liquid crystal cells are used for the liquid crystal shutters.

Also, even in the case where the passive liquid crystal cells arranged in staggered fashion make up each of three shutter rows of a liquid crystal shutter, the shutter operation is not hampered by the interference which otherwise might occur between the adjoining shutter rows due to the electric field generated between the lead electrodes of the central shutter row and the cell electrodes and the common electrode of the left and right shutter rows.

### BRIEF DESCRIPTION OF THE DRAWINGS

The above and other objects, features and advantages will be made apparent by the detailed description of embodiments taken in conjunction with the accompanying drawings, in which:
Fig. 1A is a perspective view for explaining the operation of forming a latent image on a photosensitive medium by an exposure device having a liquid crystal shutter built therein;
Pig. 1B is a sectional view taken in line B-B in Fig. 1A;
Fig. 2A is a plan view schematically showing a liquid crystal shutter for the exposure device according to a first embodiment of the invention;
Fig. 2B is a diagram for explaining the problem points of exposure by the conventional liquid crystal shutter for the exposure device comprising three-color shutter rows in a narrowly spaced relation with each other;
Fig. 3 is a schematic sectional view taken in line A-A of the liquid crystal shutter for the exposure device shown in Fig. 2A;
Fig. 4 is a partly enlarged view of the liquid crystal shutter rows of the exposure device shown in Fig. 2A for explaining the pattern in which the cell electrodes are arranged and the pitches at which the electrodes and shutter rows are arranged;
Fig. 5A is a diagram for explaining the exposure of a photosensitive medium by the liquid crystal shutter for the exposure device shown in Fig. 2A;
Fig. 5B is a diagram for explaining the pitches of the open cells of the liquid crystal shutter;
Fig. 5C is a diagram for explaining the exposure of the photosensitive medium at the Nth and (N+M) th exposure sessions by the liquid crystal shutter shown in Fig. 5B;
Fig. 5D is a diagram for explaining the movement of the center line of the recording dots generated in continuous feed of the photosensitive medium at the time of exposure;
Fig. 5E is a diagram for explaining the control operation to change the cell opening time in accordance with the tone in such a manner as to attain the coincidence of the open drive reference time of the liquid crystal shutters;
Fig. 6 is a plan view schematically showing a liquid crystal shutter for the exposure device according to a second embodiment of the invention;
Fig. 7 is a sectional view taken in line A-A schematically showing the liquid crystal shutter for the exposure device shown in Fig. 6;
Fig. 8 is a partly enlarged view, of the liquid crystal shutter rows for the exposure device shown Fig. 6, for explaining the layout pattern of the cell electrodes, the pitches at which the electrodes and the shutter rows are arranged, and the relation between the width of the partitioning wall and the pitches at which the shutter rows are arranged;
Fig. 9 is a plan view schematically showing a liquid crystal shutter for the exposure device according to a third embodiment of the invention;
Fig. 10 is a plan view schematically showing a liquid crystal shutter for the exposure device according to a fourth embodiment of the invention;
Fig. 11 is a partly enlarged view showing a pattern example of the ordinary cell electrodes and the lead electrodes of the liquid crystal shutters according to the first to fourth embodiments of the invention;
Fig. 12 is a sectional view taken in line A-A in Fig. 11;
Fig. 13 is a plan view schematically showing a liquid crystal shutter for the exposure device according to a fifth embodiment of the invention;
Fig. 14A is a partly enlarged view showing the lower part of the liquid crystal shutter shown in Fig, 13;
Fig. 14B is a sectional view taken in line B-B in Fig. 14A;
Fig. 15 is a plan view schematically showing a liquid crystal shutter for the exposure device according to a sixth embodiment of the invention;
Fig. 16A is a partly enlarged view showing the lower part of the liquid crystal shutter shown in Fig. 15;
Fig. 16B is a sectional view taken in line B-B of Fig. 16A; and
Fig. 17 is a flowchart showing the steps of fabricating a liquid crystal shutter for the exposure device according to this invention.

### BEST MODE FOR CARRYING OUT THE INVENTION

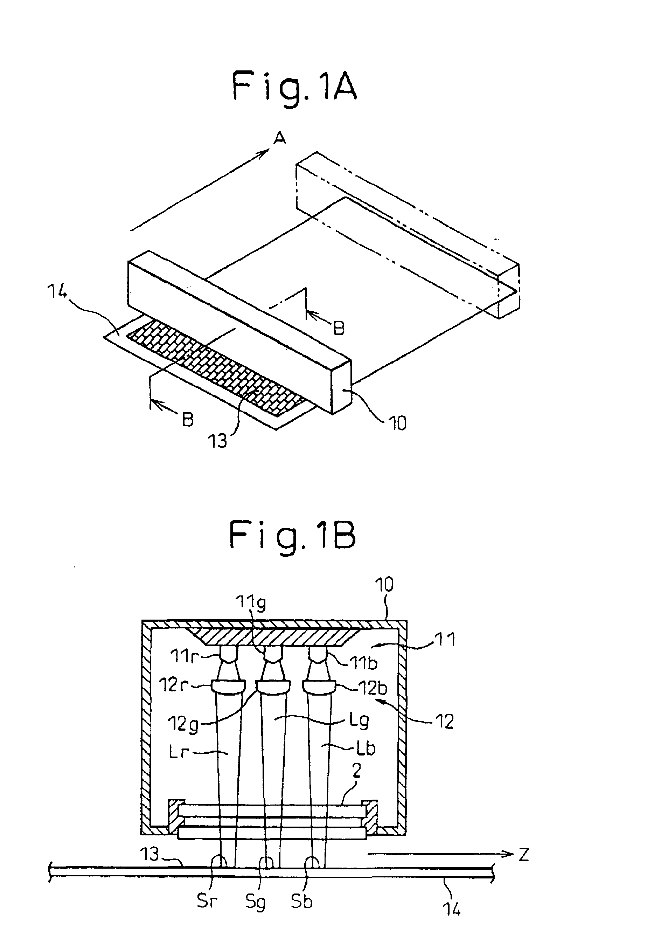

Fig. 1A is for explaining the operation of forming a latent image 13 on a photosensitive medium 14 by an exposure device 10 having a liquid crystal shutter built therein. This diagram shows the manner in which the latent image 13 is formed on the photosensitive medium 14 as the exposure device 10 moves at a predetermined speed in the direction of arrow A on the photosensitive medium 14. An example of the internal structure of the exposure device 10 is shown in Fig. 1B

The exposure device 10 has, in the housing thereof, a light source 11, a condensing optical system 12 and a liquid crystal shutter 2. The light source 11 is divided into a R light source 11r, a G light source 11g and an B light source 11b. The condensing optical system 12 includes a R light lens 12r, a G light lens 12g and a B light lens 12b. The color light Lr, Lg and Lb output from the R light source 11r, the G light source 11g and the B light source lib, respectively, are condensed by lenses 12r, 12g and 12b, respectively, and after the transmission thereof being controlled by the liquid crystal shutter 2 having liquid crystal shutter rows of the respective colors, are focused to form images at points Sr, Sg and Sb, respectively, on the photosensitive medium 14.

The color light sources 11r, 11g and lib are linear light sources having a predetermined length and are configured of a plurality of light-emitting diodes or fluorescent tubes for emitting the light of each color and color filters. The color light sources 11r, 11g and lib are arranged with the longitudinal side thereof in the direction perpendicular to the page. At the image-forming points Sr, Sg and Sb on the photosensitive medium 14, therefore, the photosensitive medium 14 is exposed in bright lines.

In recording an image on the photosensitive medium 14, the color light sources 11r, 11g and 11b are caused to emit light continuously, the transmission through the liquid crystal shutter rows for each color of the liquid crystal shutter 2 is controlled by a control unit not shown and, by feeding the photosensitive medium 14 while at the same time it is exposed for each color, a color latent image is formed on the photosensitive medium 14 thereby making it possible to carry out a predetermined subsequent development process.

In the case of Fig. 1A, the photosensitive medium 14 is fixed while the exposure device 10 is fed at a predetermined rate along the direction of arrow A in the drawing by a conveyor mechanism not shown. In the case of Fig. 1B, on the other hand, the exposure device 10 is fixed while the photosensitive medium 14 is fed at a predetermined rate, in the direction of arrow Z in the drawing, by a conveyor mechanism not shown. As can be seen from this, the exposure device 10 and the photosensitive medium 14 are moved relatively to each other at a uniform rate.

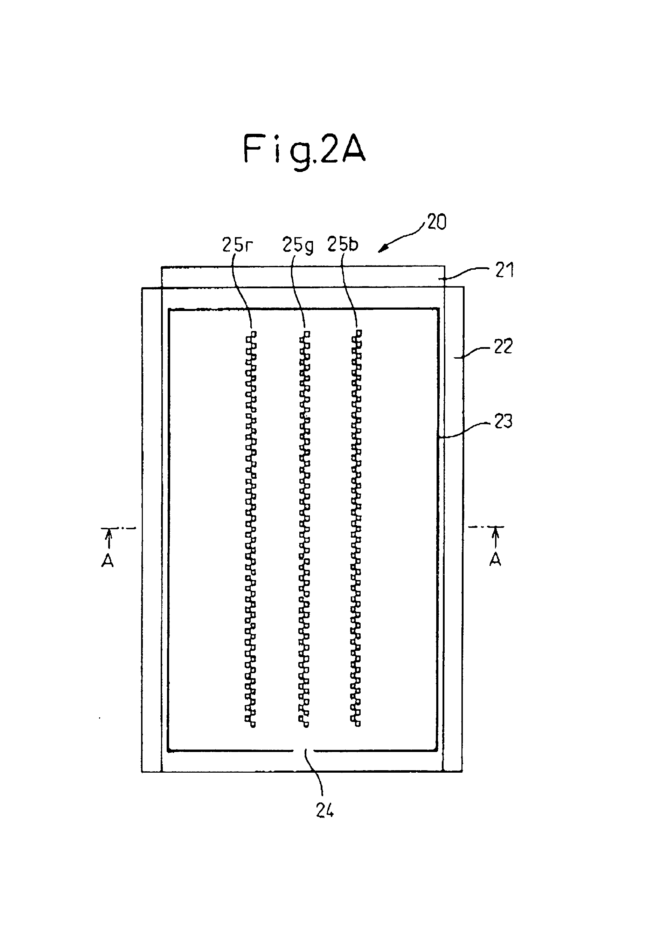

Fig. 2A is a plan view of a liquid crystal shutter 20 for the exposure device according to a first embodiment of the invention. The liquid crystal shutter 20 includes two glass substrates 21, 22 held in a slightly spaced relation in parallel with each other, and the outer periphery of the overlapped portion thereof is sealed with a seal member 23. After filling liquid crystal into the space between the substrates by injection from an injection hole 24 formed in the seal member 23, the injection hole 24 is sealed with an ultraviolet light-cured resin or the like. The liquid crystal shutter 20 includes a R light liquid crystal shutter row 25r, a G light liquid crystal shutter row 25g and a B light liquid crystal shutter row 25b.

Each shutter row 25 has a transparent common electrode with a plurality of cells formed on the glass substrate 21, and a transparent cell electrode formed on the glass substrate 22. By applying a voltage to each transparent electrode, the light transmission of each cell is controlled. Thus, each cell is required to be wired to the transparent cell electrode and, in order to improve the resolution of the image formed on the color photosensitive medium, a plurality of the cells making up each liquid crystal shutter row are required to be arranged, as closely as possible to each other, along the direction of the bright line of the light transmitted through the liquid crystal shutter row. Also, in order to arrange the cells as closely as possible to each other while securing a wiring space, the cells making up the liquid crystal row of each color are arranged in two rows in a staggered fashion.

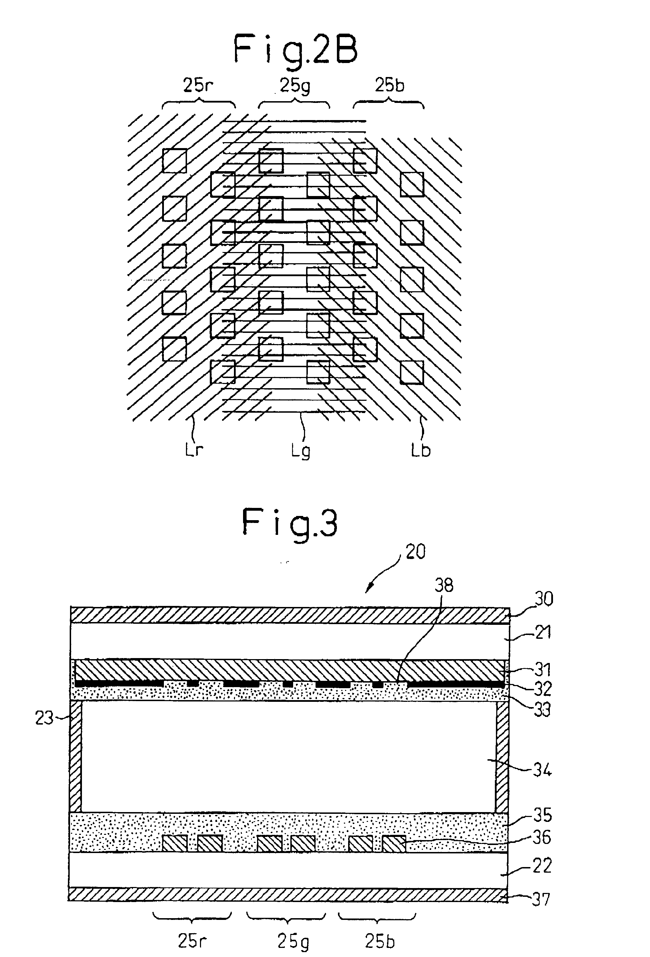

According to this invention, a passive liquid crystal is used for each liquid crystal cell (liquid crystal switch) forming a pixel requiring no switching element such as a transistor. Therefore, the liquid crystal shutter rows of the respective colors are arranged on the glass substrate 22 in a sufficiently spaced relation with each other as described later. If the space between the liquid crystal shutter rows of the respective colors is small, the colors would be undesirably superposed one on the other depending on the width of the color light Lr, Lg and Lb shown in Fig. 1B. This will be explained with reference to Fig. 2B. Fig. 2B is a partly enlarged view of the conventional liquid crystal shutter for the exposure device having narrow spaces between the three-color shutter rows 25r, 25g and Z5b. If the three-color shutter rows 25r, 25g and 25b do not have sufficient spatial intervals, as in this case, part of each color light Lr, Lg and Lb is superposed with an adjoining color liquid crystal shutter row by the width of the color light Lr, Lg and Lb, resulting in an overlapped color, in view of this, according to this invention, the color overlap is prevented by setting a sufficient spatial interval between the three color shutter rows 25r, 25g and 25b.

Fig. 3 is a sectional view taken in line A-A schematically showing the liquid crystal shutter for the exposure device shown in Fig. 2A. In the first embodiment, a transparent common electrode 31 of a transparent ITO thin film or the like is formed over the entire lower surface of the glass substrate 21 on the light source (upper) side, and the surface side of the transparent common electrode 31 is formed with a masking layer 32 and an orientation film 33 of polyimide, or the like, in a stack. Also, the upper surface of the lower glass substrate 22 is formed with fine transparent cell electrodes 36 each in two staggered rows and is covered with an orientation film 35. The outer periphery of the glass substrates 21, 22 is sealed with a seal member 23 of epoxy resin or the like, and the liquid crystal 34 is filled between the orientation films 33, 35 of the substrates 21, 22. The thickness of the liquid crystal 34 is set to 5 µm. The masking layer 32 formed on the transparent common electrode 31 is configured of such a material as chromium, and slits 38 are formed at the portions of the masking layer 32 corresponding to the transparent cell electrodes 36, so that light is transmitted only through the particular portions. Deflectors 30, 37 are arranged outside of the substrates 21, 22, respectively.

Further, the liquid crystal 34 according to the first embodiment is activated in STN mode with the twist angle of, say, 240°, and the two deflectors 30, 37 have deflection axes crossed at a corresponding angle.

As shown in Fig. 3, the transparent common electrode 31 and the transparent cell electrodes 36 make up the R light liquid crystal shutter row 25r, the G light liquid crystal shutter row 25g and the B light liquid crystal shutter row 25b. In the case under consideration, the size of each of the cells making up each liquid crystal shutter row is set to a square of 85 x 85 µm.

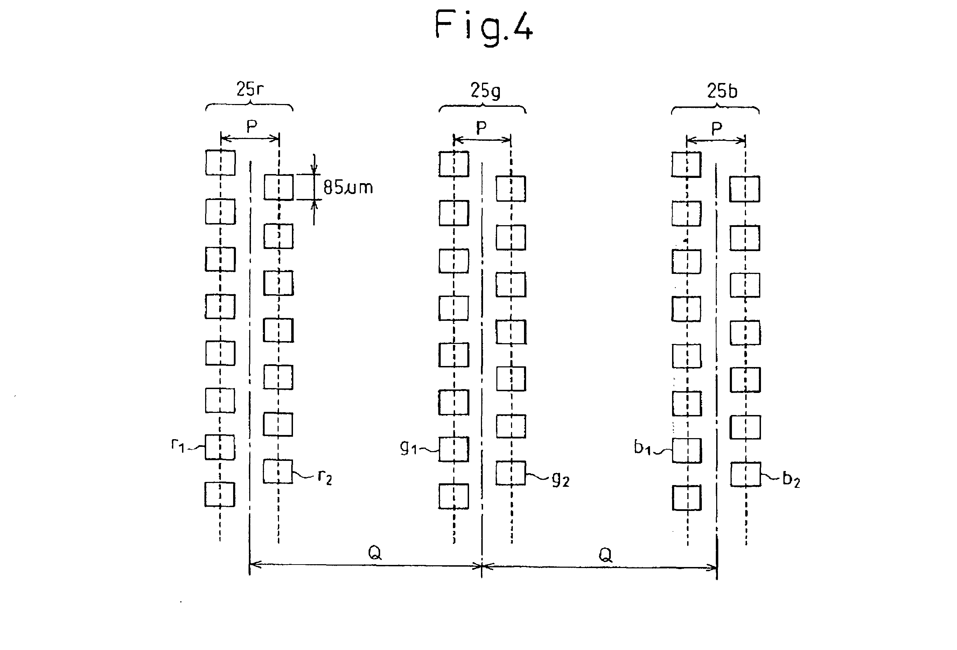

Fig. 4 is a partly enlarged view of the shutter rows 25r, 25g, 25b of the liquid crystal shutter for the exposure device shown in Fig. 2A. This diagram is used for explaining the pattern in which the cell electrodes are arranged and the pitches at which the electrodes and the shutter rows are arranged. The liquid crystal shutter rows 25r, 25g, 25b of the respective colors are each configured of a plurality of cells arranged in two staggered rows. Also, the pitch P between the cell rows making up each of the liquid crystal shutter rows 25r, 25g, 25b is set to 170 µm in all cases. Further, the pitch Q between the liquid crystal shutter rows 25r, 25g, 25b of the respective colors is set larger than the pitch P between the cell rows, According to the first embodiment, for example, the pitch Q of the shutter rows is set to 7820 µm, i.e. 46 times as large as the pitch P of the cell rows.

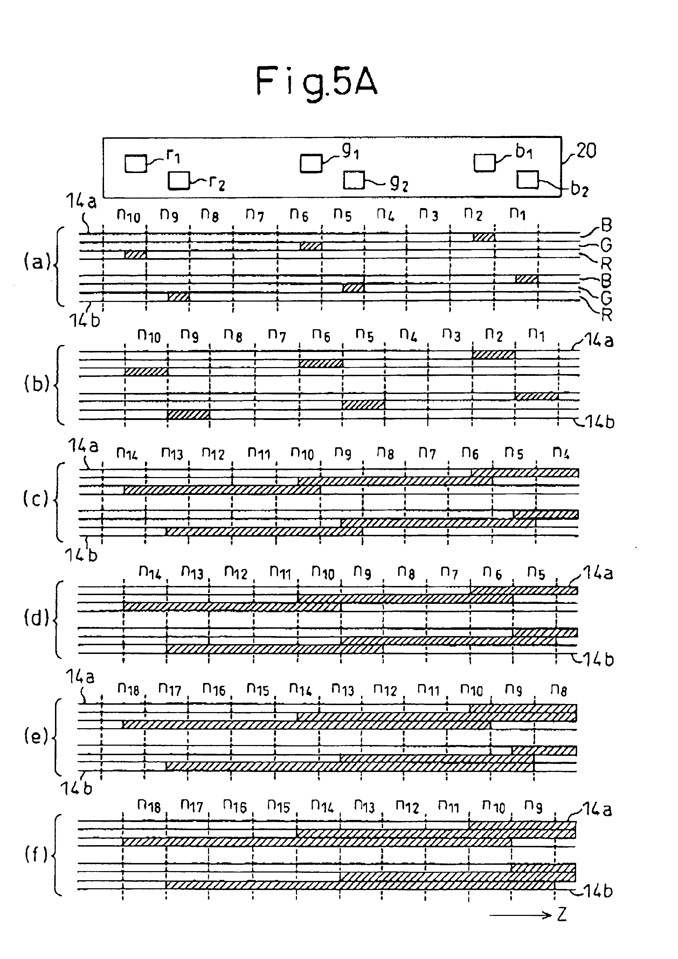

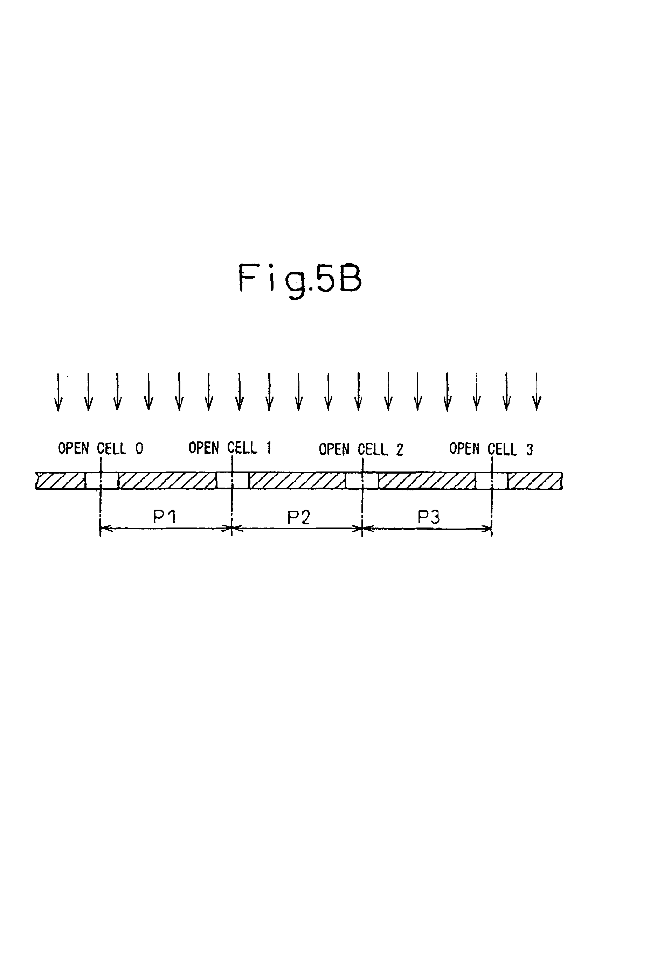

Next, the exposure of the photosensitive medium with the cells arranged in two staggered rows will be explained with reference to Fig. 5A. With reference to Fig. 5A, an explanation will be given about the exposure with the two cells r1, r2 of the R light liquid crystal shutter row 25r, the two cells g1, g2 of the G light liquid crystal shutter row 25b and the two cells b1, b2 of the B light liquid crystal shutter row 25b of the liquid crystal shutter 20. Numeral 14a designates a part corresponding to the cells r1, g1, b1, and numeral 14b a part corresponding to the cells r2, g2, b2 on the photosensitive medium 14. The photosensitive medium 14 is assumed to have at least an R photosensitive layer reactive to the R light, a G photosensitive layer reactive to the G light and a B photosensitive layer reactive to the B light. Further, the photosensitive medium 14 is assumed to be fed at a predetermined rate along the direction of arrow Z. In Fig. 5A, by way of explanation, the pitch Q of the liquid crystal shutters of the respective colors is set to an integer multiple other than 46 times the cell row pitch P as shown in Fig. 4.

In Fig. 5A, (a) designates the state of the parts 14a, 14b on the photosensitive medium 14 at time T1. Specifically, (a) in Fig. 5A shows the manner in which the exposure of the area n2 of the part 14a is started by the cell b1, the exposure of the area n6 by the cell g1 and the exposure of the area n10 by the cell r1 and, in similar fashion, the manner in which the exposure of the area n1 of the part 14b is started by the cell b2, the exposure of the area n5 by the cell g2 and the exposure of the area n5 by the cell r2.

In Fig. 5A, (b) designates the state at time T2 upon the lapse of a predetermined time length from the state (a) of Fig. 5A, in which the exposure is completed for the area n2 of the part 14a by the cell b1, for the area n6 of the part 14a by the cell g1 and for the area n10 of the part 14a by the cell r1. In similar fashion, the exposure of the area n1 of the part 14b is completed by the cell b2, the exposure of the area n5 of the part 14b by the cell g2, and the exposure of the area n9 by the part 14b of the cell r2.

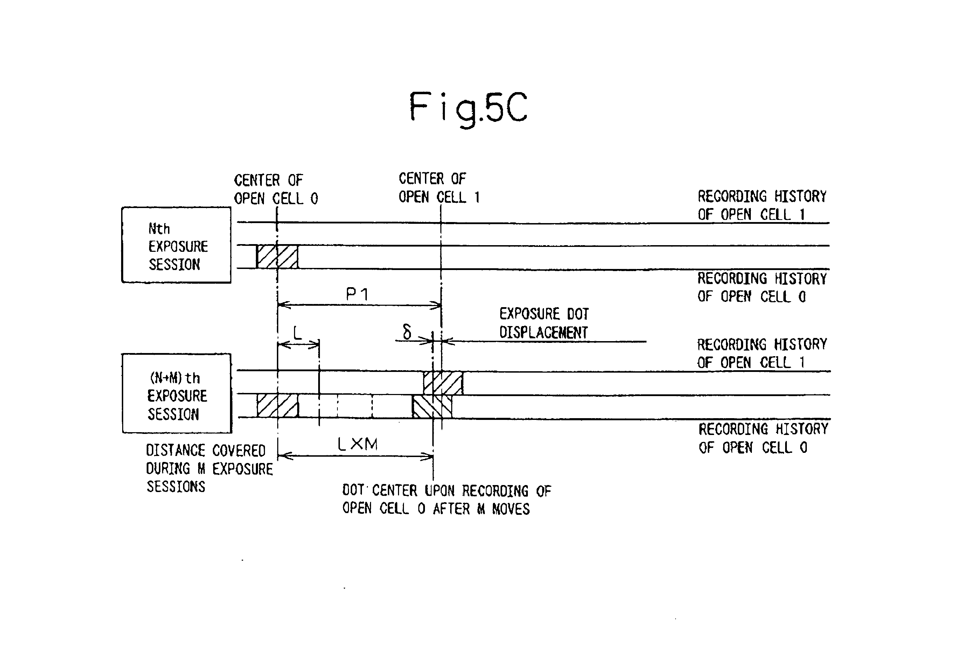

In Fig. 5A, (c) designates the state at time T3 upon further lapse of time from state (b) in Fig. 5A. Specifically, the exposure of the area n6 of which exposure has been completed by the cell g1 is started by the cell b1, the exposure of the area n10 of which exposure has been completed by the cell r1 is started by the cell g1. In similar fashion, the exposure of the area n5 of which exposure has been completed by the cell g2 is started by the cell b2, and the exposure of the area n9 of which exposure has been completed by the cell r2 is started by the cell g2.

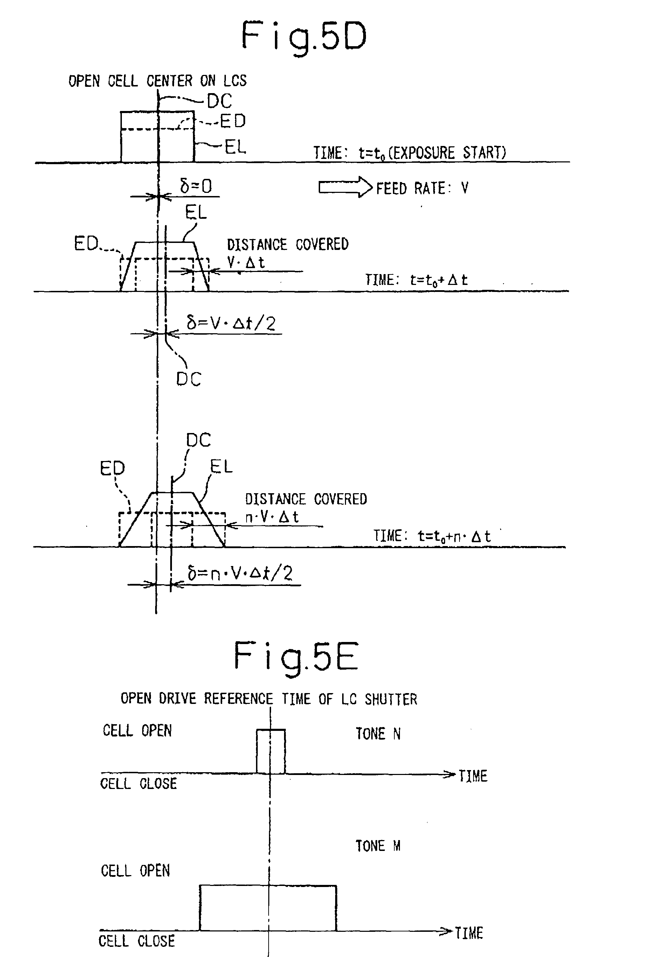

In Fig. 5A, (d) designates the state at time T4 upon the lapse of a predetermined time length from state (c) of Fig. 5A. Specifically, it shows that the exposure of the area n6 of the part 14a is completed by the cell b1, the exposure of the area n10 of the part 14a by the cell g1 and the exposure of the area n14 of the part 14a by the cell r1. In similar fashion, the exposure of the area n5 of the part 14b is completed by the cell b2, the exposure of the area n9 of the part 14b by the cell g2 and the exposure of the area n13 of the part 14b by the cell r2.

In Fig. 5A, (e) designates the state at time T5 upon the lapse of a further time length from state (d) of Fig. 5A. Specifically, it shows the manner in which the exposure of the area n10 of which exposure has been completed by the cells r1, g1 is started by the cell b1. In similar fashion, it shows that the exposure of the area n9 of which exposure has been completed by the cells r2, g2 is started by the cell b2.

In Fig. 5A, (f) designates the state at time T6 upon the lapse of a predetermined time length from state (d) of Fig. 5A. Specifically, it shows that the exposure of the area n10 of the part 14a is completed by the cell b1, thereby completing the exposure of the area n10 by the R, G and B light. In similar fashion, it shows that the exposure of the area n9 of the part 4b of the photosensitive medium 14b is completed by the cell b2, thereby completing the exposure of the area n9 of the photosensitive medium 14b by the R, G and B light by the cell b2. The operation steps (a) to (f) of Fig. 5A are repeatedly carried out to thereby form a latent image for a color image at the parts 14a, 14b on the photosensitive medium 14.

As shown in Fig. 5A, the liquid crystal shutter rows for the respective colors each include two cell rows, and are arranged at mutually distant positions. in the case where the pitch Q of the liquid crystal shutter line for each color is set to an integer multiple of the pitch P of the two cell rows making up the liquid crystal shutter row for each color, the exposure position on the photosensitive medium by the liquid crystal shutter line for each color can be easily set in position. In Fig. 4, pitch P of the cell rows and the pitch Q of the liquid crystal shutter rows are set to the ratio of 1 to 46. Nevertheless, the pitch Q of the liquid crystal shutter rows can be set to an integer multiple of the pitch P of the cell rows. In other words, the purpose is served when Q = NP, where N is a positive integer larger than 2.

The necessity of setting the pitch Q of the liquid crystal shutter rows to an integer multiple of the pitch P of the cell rows will be explained. This invention is applicable a case in which the exposure is carried out at the same time by a plurality of shutter rows in predetermined spaced relation with each other. In such a case, the simultaneous exposure for a plurality of rows may be carried out either with the same color or with two or more colors.

First, an explanation will be given about a case in which the photosensitive medium is fed intermittently at the time of exposure. While the exposure is under way, the recording head including the liquid crystal shutter and the photosensitive medium are in relatively fixed positions. After the exposure operation, the recording head and the photosensitive medium are moved relatively to each other by a length corresponding to the recording dot pitch to be expressed on the photosensitive medium. At the particular position, the recording head and the photosensitive medium are stopped in relatively fixed positions and start the next session of the exposure operation. This operation pattern is repeated.

As shown in Figs. 5B, 5C, if that the distance P1 between the center of the open cell 0 and the center of the open cell 1 of the liquid crystal shutter is not limited in any way and if the basic distance coverage between the exposure sessions is given as the pitch L of the recording dots defining the resolution on the photosensitive medium and that the dot exposed on the photosensitive medium from the open cell 0 at the Nth exposure session has approached the center position of the open cell 1 after repetition of M exposure sessions, as the result of the M sessions of movement (exposure), the recording dot recorded from the open cell 0 at the Nth exposure session covers the distance equivalent to L x M. In the above process, of all the conceivable values of L x n (n: arbitrary number of exposure sessions), the value taken when n = M is nearest to the distance P1 between the center of the open cell 0 and the center of the open cell 1.

The difference δ between the distance L x M and the distance P1 (δ: a positive number smaller than pitch L, and equal to P1 - L x M) represents the displacement between the recording dot exposed by the open cell 0 and the recording dot exposed by the open cell 1. The displacement of the dots which otherwise should be aligned on the photosensitive medium leads to a reduced image resolution and is an undesirable phenomenon in forming an image. Thus, it is effective to assure that δ = 0.

In other words, adjoining open cell rows are required to be arranged on the liquid crystal shutter with the distance P1 = L x M, where M may not be a specific value but is required to be an integer. The same spatial relation holds true also for the intervals P2, P3 between the cell rows existing on the same liquid crystal shutter. In short, the distance between adjoining cell rows existing on the same liquid crystal shutter is required to be an integer multiple of the dot pitch indicating the resolution defined on the photosensitive medium formed of the particular liquid crystal shutter.

Next, an explanation will be made about a case in which the photosensitive medium is continuously fed in exposure mode. The relative positions of the recording head including the liquid crystal shutter and the photosensitive medium undergo a change at a constant rate even during the exposure. The rate of this relative movement is not changed with the relative positions of the recording head and the photosensitive medium or with the condition of the exposure operation, but the relative movement continues from the start to the end of the exposure operation for the same photosensitive medium. In this case, a predetermined exposure operation is repeated each time the relative positions of the recording head and the photosensitive medium move by the distance equivalent to the recording dot pitch defining the resolution to be recorded on the photosensitive medium.

Even in the case where the photosensitive medium is fed continuously at the time of exposure, the exposure dots are arranged at each recording dot pitch described above as long as the exposure time per dot remains constant for dot exposure. Therefore, the conditions required for arranging a plurality of open cell rows on the liquid crystal shutter are exactly the same as those in the case where the photosensitive medium is intermittently fed at the time of exposure.

In a method of keeping a constant exposure time per dot at the time of dot exposure for recording, the liquid crystal shutter is driven by high-speed pulses and the transmittance of the liquid crystal shutter during a predetermined time is changed by changing the drive frequency of the liquid crystal shutter thereby to express the tone. In this method, the exposure per dot on the photosensitive medium leads to the fact that the cell open time of the liquid crystal shutter remains the same from the start to the end of exposure on the same photosensitive medium.

In addition to the aforementioned method of keeping a constant exposure time with high-speed pulses, a method of exposure on the photosensitive medium using a liquid crystal shutter for expressing the tone of the recording dots consists in controlling the total exposure amount of light radiation by changing the open time of the cells of the liquid crystal shutter.

In the case where exposure is started from a specified time point for expressing an arbitrary tone when attaching a tone to the recording dots, the recording dot position may undesirably move while the photosensitive medium is fed continuously. This phenomenon will be explained with reference to Fig. 5D.

In Fig. 5D, the dotted line ED indicates the exposure profile at an arbitrary time point, the solid line EL the total sum (in the form of recording dot) of the exposure profile up to an arbitrary time point, and the one-dot chain DC the center line of the recording dot.

As shown in Fig. 5D, regardless of whichever tone is expressed, in the case where the opening operation of the cell of the liquid crystal shutter from a specified time point, the center line DC of the recording dot is moved by an amount depending on one half of the distance covered by the photosensitive medium before the end of the cell opening operation. Once this phenomenon occurs, the positions of the recording dots which otherwise should be aligned are moved with the tone change, thereby reducing the power of reproducing a straight line. In order to avoid this phenomenon, the tone expression of the recording dots is controlled according to the open time of the cells on the liquid crystal shutter by the method of continuously moving the photosensitive medium. In this case, the position of the center line of the recording dot remains fixed without regard to the tone at the time of exposure of the recording dots.

In this method, for example, a specified time point is set as a reference time, and the open time is controlled in such a manner that the central open time point of the liquid crystal shutter for tone variation always coincides with the time point of the center line DC of the recording dot for expression of any tone.

According to this drive method, as shown in Fig. 5E, the cell opening start time for the tone N is differentiated from the cell tone starting time for the tone M (> N). This driving method makes it possible that the central position of the recording dot coincides with a point corresponding to the central position of the open cell of the liquid crystal shutter on the surface of the photosensitive medium at the open drive reference time of the liquid crystal shutter.

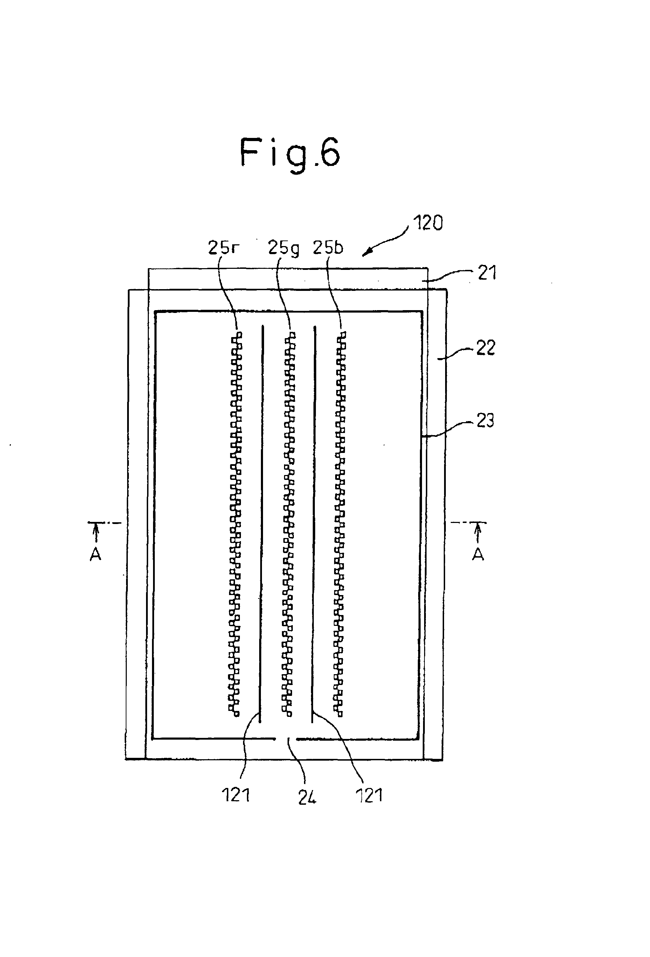

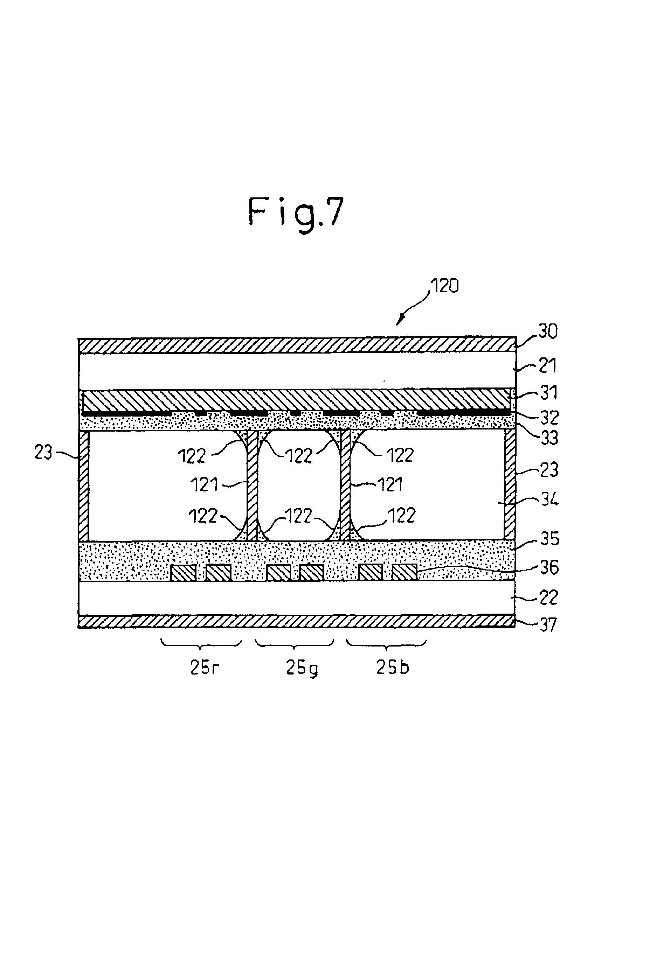

Fig. 6 shows a configuration of the liquid crystal shutter 120 for the exposure device according to a second embodiment of the invention. Fig. 7 is a sectional view taken in line A-A schematically showing the liquid crystal shutter 120 of Fig. 6. The liquid crystal shutter 120 according to the second embodiment is different from the liquid crystal shutter 20 according to the first embodiment explained with reference to Fig. 2A only in that a spacer 121 in the form of a partitioning wall is interposed between the liquid crystal shutter rows 25r and 25g and between the liquid crystal shutter rows 25g and 25b. with regard to the liquid crystal shutter 120 according to the second embodiment, therefore, only the difference with respect to the liquid crystal shutter 20 according to the first embodiment will be explained. Thus, the same component parts of the liquid crystal shutter 120 as those of the liquid crystal shutter 20 according to the first embodiment are designated by the same reference numerals, respectively, and will not be explained.

Now, an explanation will be given about the reason why the spacer 121 in the form of a partitioning wall is formed between the liquid crystal shutter rows 25r and 25g and between the liquid crystal shutter rows 25g and 25b.

If, for example, a drive voltage is applied to one of the transparent cell electrodes of the liquid crystal shutter row 25r and the liquid crystal molecules facing the particular electrode are activated, the motion of the liquid crystal molecules would have an effect on the adjoining liquid crystal shutter row 25g and on the operation of the cells of the liquid crystal shutter row 25g, thereby reducing the resolution. Each spacer 121 in the form of a partitioning wall interposed between the liquid crystal shutter rows is for preventing the interference between the liquid crystal shutter rows. The provision of the spacer 121 between the adjoining liquid crystal shutter rows has an additional effect of increasing the mechanical strength for an improved shock resistance of the liquid crystal shutter 120 as a whole.

On the other hand, when the epoxy resin or the like of the spacers 121 is thermally set, a gas is generated and it corrodes the orientation films 33, 35 on the glass substrate. Therefore, the response of the liquid crystal 34 to the drive voltage deviates from the original degree. Specifically, areas called fringe portions 122 exist in the neighborhood of the orientation films 33, 35 of each spacer 121 as shown in Fig. 7, where the light transmittance becomes irregular. Once a liquid crystal shutter row is arranged in overlapped relation with a fringe portion 122, the transmittance of the liquid crystal shutter would lose uniformity. In the liquid crystal shutter 120, therefore, the liquid crystal shutter rows 25r, 25g, 25b for the respective colors are formed in areas other than the areas of the fringe portions 122.

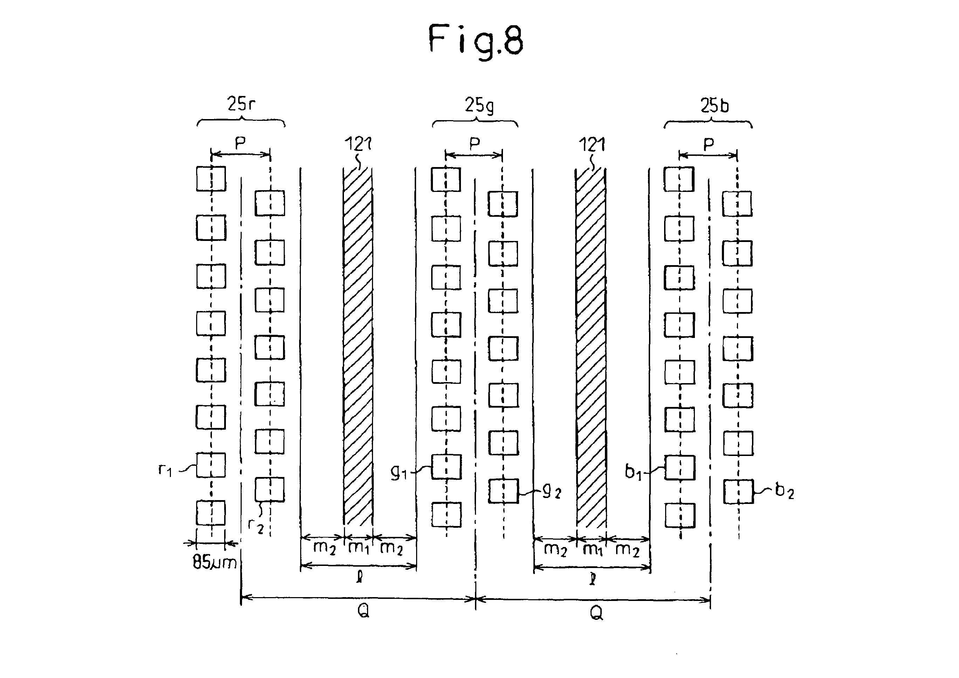

Fig. 8 is a partly enlarged view of the liquid crystal shutter rows 25r, 25g, 25b for the respective colors and the spacers 121. In the liquid crystal shutter rows 25r, 25g, 25b shown in Fig. 8, like in Fig. 4, the pitch P between the cell rows is set to 170 µm, and the pitch Q between the liquid crystal shutters to 7820 µm, or 46 times as large as the pitch P between the cell rows. Also, in Fig. 8, characters m1 designates the width of each spacer 121, and characters m2 the width of each fringe portion 122. As described above, the pitch Q between the liquid crystal shutter rows 25r, 25g, 25b is desirably an integer multiple of the pitch P between the cell rows. Further, the pitch Q is desirably longer than the distance (= m1 + 2 x m2) equal to the sum of the width m1 of the spacer 121 and the double (left and right portions) of the width m2 of the fringe portion 122.

Normally, the spacer width m1 is desirably set to 0.6 to 1.5 µm. In the case where the thickness of the liquid crystal 34 is 5 µm, therefore, the width m2 of the fringe portion 122 should be considered not less than 2 mm. As a result, the pitch Q is desirably longer than 4 mm.

As described above, the liquid crystal shutter 120 according to the second embodiment has a uniform transmittance in view of the fact that the liquid crystal shutter rows 25r, 25g, 25b for the respective colors are arranged in areas other than the areas of the fringe portions 122.

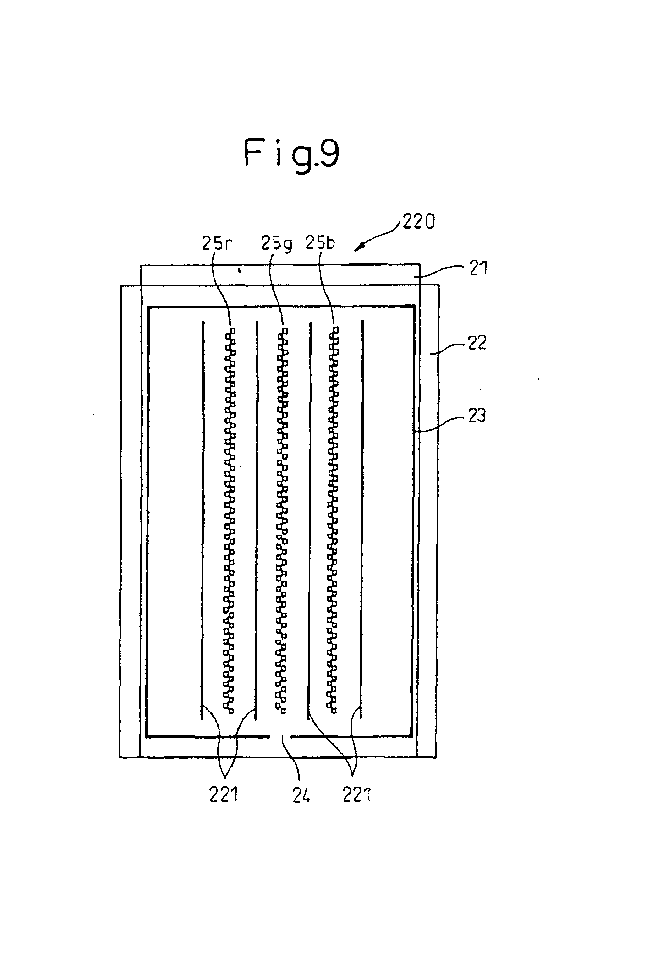

Fig. 9 shows a configuration of a liquid crystal shutter 220 for the exposure device according to a third embodiment of the invention. The liquid crystal shutter 220 according to the third embodiment is different from the liquid crystal shutter 120 according to the second embodiment only in that a spacer 221 in the form of a partitioning wall is interposed not only between the liquid crystal shutter rows 25r, 25g and between the liquid crystal shutter rows 25g, 25b but also outside each of the liquid crystal shutter row 25r and the liquid crystal shutter row 25b. With regard to the liquid crystal shutter 220 according to the third embodiment, therefore, only the difference with the liquid crystal shutter 120 according to the second embodiment will be explained. Thus, the same component parts as the corresponding ones of the liquid crystal shutter 120 according to the second embodiment will be designated by the same reference numerals, respectively, and will not be explained.

The spacer 221 is also arranged outside each of the liquid crystal shutter row 25r and the liquid crystal shutter row 25b as shown in Fig. 9. In the case where the liquid crystal is activated by applying a drive voltage to the cell electrodes of the liquid crystal shutter rows 25r, 25g, 25b, therefore, the capacity of the liquid crystal for each cell row is substantially the same in all the liquid crystal shutter rows. By keeping a substantially constant capacity of the liquid crystal for each of the liquid crystal shutter rows 25r, 15g, 25b as shown in Fig. 9, the shutter operation of the liquid crystal shutter rows 25r, 25g, 25b can be advantageously controlled with higher uniformity (isolation effect).

Also in the third embodiment, the liquid crystal shutter rows 25r, 25g, 25b are desirably arranged at different places from the spacers 221 and the fringe portions (Fig. 7) developed from the spacers 221, while at the same time setting the pitch Q of the liquid crystal shutter rows at an integer multiple of the pitch P of the cell rows.

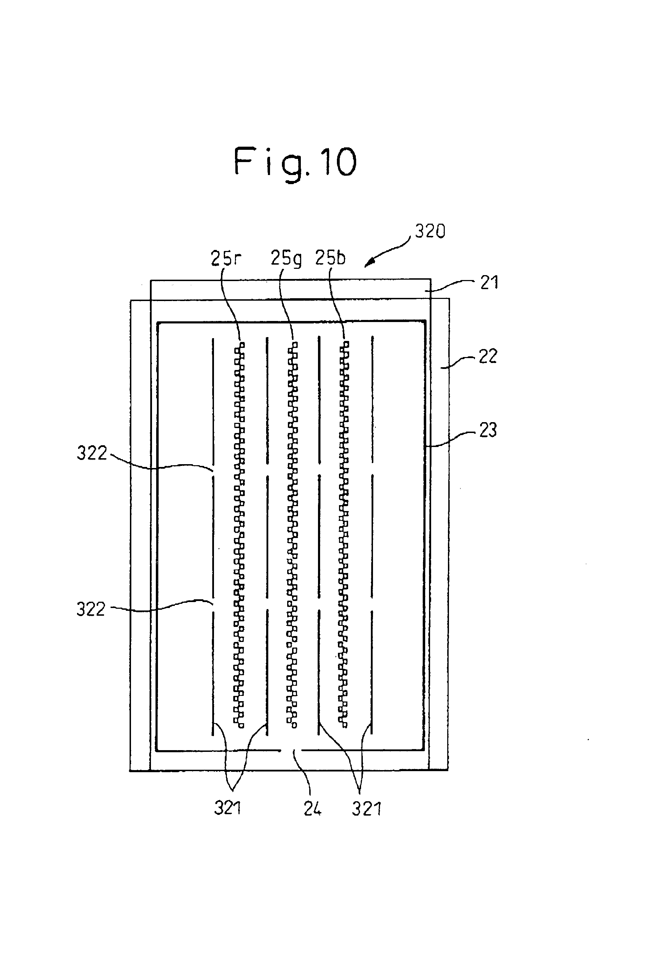

Fig. 10 shows a configuration of a liquid crystal shutter 320 for the exposure device according to a fourth embodiment of the invention. The liquid crystal shutter 320 according to the fourth embodiment is different from the liquid crystal shutter 220 according to the third embodiment explained with reference to Fig. 9 only in that in the liquid crystal shutter 320 according to the fourth embodiment, the spacers 221 in the form of a partitioning wall, arranged between the liquid crystal shutter rows 25r, 25g, between the liquid crystal shutter rows 25g, 25b, outside the liquid crystal shutter row 25r and outside the liquid crystal shutter row 25b, are each replaced with a spacer 321 having intermediate notches 322. With the liquid crystal shutter 320 according to the fourth embodiment, therefore, only the difference with respect to the liquid crystal shutter 220 according to the third embodiment will be explained, and the same component members as those of the liquid crystal shutter 220 according to the third embodiment will not be explained while designating them by the same reference numerals, respectively.

In view of the fact that each spacer 321 has the notches 322 as shown in Fig. 10, the liquid crystal filled in by injection from the injection hole 24 flows smoothly and extends over the whole area without adversely affecting the isolation effect of the liquid crystal shutter rows 25r, 25g, 25b, thereby leading to the advantage that the shutter operation of the liquid crystal shutter rows 25r, 25g, 25b can be controlled with a higher uniformity.

Also in the liquid crystal shutter 320 according to the fourth embodiment, the liquid crystal shutter rows 25r, 25g, 25b are desirably arranged at places different to the places of the spacers 321 and the fringe portions (Fig. 7) developed from the spacers 321, while setting the pitch Q of the liquid crystal shutter rows to an integer multiple of the pitch P of the cell rows.

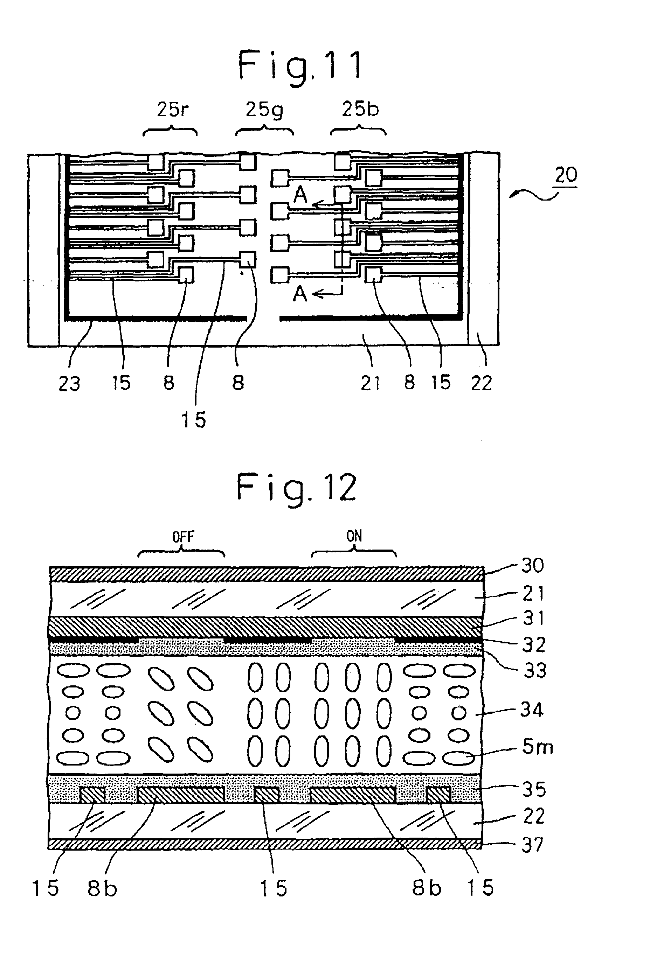

Fig. 11 is an enlarged view of a pattern example of the ordinary cell electrodes 8 and the lead electrodes 15 of the liquid crystal shutters according to the first to fourth embodiments of the invention. The liquid crystal shutter 20 according to the first embodiment is shown as an example in Fig. 11.

Among the three liquid crystal shutter rows (cell rows) 25r, 25g, 25b corresponding to R, G, B, respectively, the lead electrodes 15 connected to the transparent cell electrodes 8 of the two shutter rows 25r, 25b are led to the ends of the transparent glass substrate 22. The lead electrodes 15 connected to the transparent cell electrodes 8 of the central shutter row 25g, on the other hand, are divided into two groups, one led to one end of the transparent glass substrate 22 and the other to the other end thereof. Among the lead electrodes 15 connected to the two rows of the transparent cell electrodes 8 of the central shutter row 25g, the transparent cell electrodes 8 of a row near to the liquid crystal shutter row 25r are led out through the space between the transparent cell electrodes 8 in two rows of the liquid crystal shutter row 25r, while the transparent cell electrodes 8 of a row near to the liquid crystal shutter row 25b are led out through the space between the transparent cell electrodes 8 in two rows of the liquid crystal shutter row 25b.

Fig. 12 is an enlarged sectional view of the liquid crystal shutter row 25b taken in line A-A in Fig. 11. As long as no drive voltage is applied to the cell electrodes 8b, the liquid crystal molecules 5m between the glass substrates 21, 22 have the long axis thereof laid horizontally with the direction thereof twisted spirally along the thickness of the layer of the liquid crystal 34 under the effect of the orientation films 33, 35. The twist angle of the STN crystal is 180°, for example. This state is shown schematically at the left and right end portions of Fig. 12. With the cell electrode 8b on the right side in Fig. 12 impressed with a drive voltage, the long axes of the liquid molecules 5m are erected in upright position perpendicular to the horizontal direction under the effect of the electric field generated between the particular cell electrode 8b and the common electrode 31. The crossing angle of the polarization axes of the polarizers 30, 37 is so selected that the primary color light incident through the polarizer 30 is not passed through the polarizer 37 when the long axes of the liquid crystal molecules 5m in the. liquid crystal layer are twisted in horizontal position, while the primary color light so incident is passed through the polarizer 37 when the long axes of the liquid crystal molecules 5m are erected in upright position in the liquid crystal layer.

At each of the left and right end portions of Fig. 12, the liquid crystal layer faces the lead electrode 15 passing between the cell electrodes. Also, at the central portion of Fig. 12, the liquid crystal layer faces the lead electrode 15 but not the cell electrode 8b. These lead electrodes 15 are connected to the cell electrodes 8, respectively, of the central shutter row 25g in Fig. 11 and impressed with the same drive voltage as the shutter row 25g. Thus, an electric field is generated by the common electrode 31, so that the liquid crystal molecules in the particular area are either laid that in horizontal direction or erected to upright position in accordance with the electric field. No drive voltage is applied to the lead electrodes 15 at the ends of Fig. 12, in which case the liquid crystal molecules at the particular portion are laid horizontally. The lead electrode 15 at the central portion of Fig. 12, on the other hand, is connected to the cell electrode impressed with the drive voltage, and therefore an electric field is generated with the common electrode 31, with the result that the liquid crystal molecules at this portion are erected in upright position.

The lead electrodes 15 are thinner than the cell electrodes 8. As in the case of the cell electrodes 8, however, an electric field is generated between the lead electrodes and the common electrode 31. Therefore, the liquid crystal molecules 5m are either laid horizontally or are erected in upright position also in this particular portion. This, this portion exhibits the function of an optical shutter. The exposure device would lose its function if light is passed through this particular portion and unnecessarily sensitizes the photographic paper. In order to block the light at this particular portion, therefore, masking layers 32 are formed in advance on the parts of the common electrode 31 of the glass substrate 21 facing the lead electrodes 15, as shown in Fig. 12.

The masking layers 32 prevent the parasitic optical shutter function due to the lead electrodes 15. Nevertheless, the problem remains unsolved that the motion of the liquid crystal molecules 5m facing the lead electrodes 15 have an effect on the position of the liquid crystal molecules 5m in the area of the neighboring cell electrodes 8. In Fig. 12, as described above, the central lead electrode 15 is connected to the cell electrodes which are turned on by a drive voltage which may be applied thereto. As a result, an electric field is created with the common electrode 31, so that liquid crystal molecules in the space formed with the common electrode 31 are erected in an upright position and are in a translucent state. The light is not passed through this portion as it is blocked by the upper masking layer 32. This motion of the liquid crystal molecules 5m, however, is propagated to the adjoining liquid crystal layers.

Even in the case where the cell electrodes 8b on the center left side in Fig. 12 are in a not-selected off state and the liquid crystal molecules 5m at this particular portion should block the light by assuming a horizontal position, the liquid crystal molecules 5m at this particular portion tend to rise under the force of the upper part of the erected liquid crystal molecules 5m of the lead electrode 15 on the immediately right side. As a result, the liquid crystal molecules 5m at this portion come to assume an oblique position and become somewhat translucent. As a result, the exposure is not according to the image data, thereby causing the color irregularities. This phenomenon may occur at all the portions where the lead electrode 15 connected with a given cell row passes between the cell electrodes 8 of another cell row, and would be a cause of a deteriorated image quality if left as it is.

In view of this, the liquid crystal shutter according to this invention has a configuration which obviates this problem and prevents image noise from being generated by the lead electrodes 15. An embodiment will be explained below.

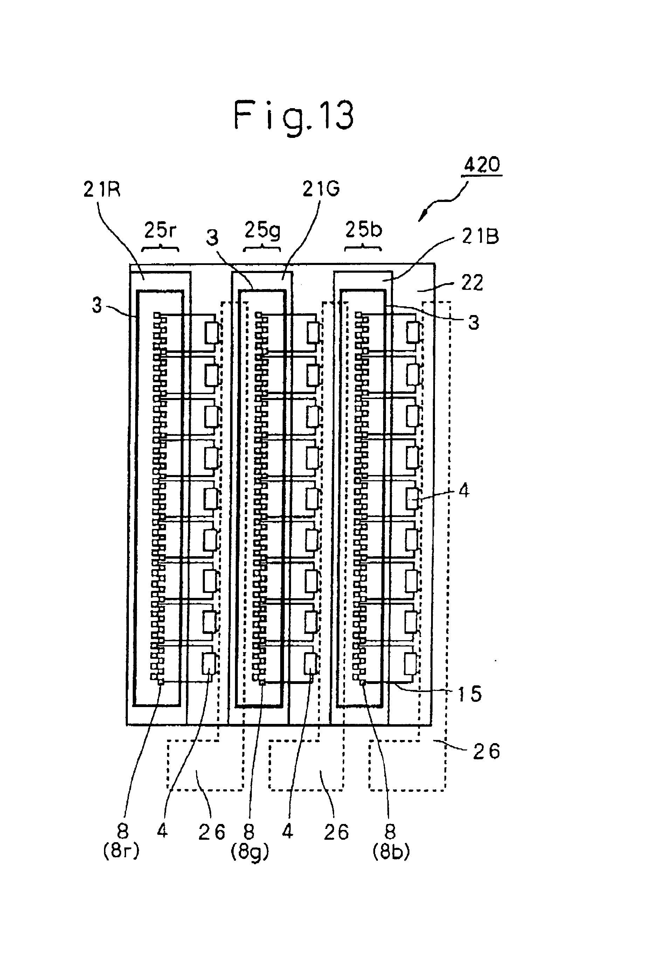

Fig. 13 shows a configuration of a liquid crystal shutter 420 according to a fifth embodiment of the invention. The glass substrate 22 is formed with three shutter rows 25r, 25g, 25b each having cell electrodes 8 (R cell electrodes 8r, G cell electrodes 8g, and B cell electrodes 8b) in staggered fashion. Substrates 21R, 21G and 21B are arranged in opposed relation with the glass substrate 22 with an intermediate gap of about 5 µm. The liquid crystal is filled between the respective substrates 21R, 21G, 21B and the glass substrate 22 and sealed with a seal member 3. Specifically, three liquid crystal shutters are formed independently of each other for each color in opposed relation with the glass substrate 22. Each liquid crystal shutter includes one of the three shutter rows 25r, 25g, 25b of R, G, B, respectively.

Also, the drive circuits 4 for the shutter rows 25r, 25g, 25b are arranged beside the opposed substrates 21R, 21G, 21B and connected to the shutter rows 25r, 25g, 25b, respectively, by the lead electrodes 15. Further, the opposed substrates 21R, 21G, 21B are led out of the glass substrate 22 by way of three flexible printed circuit boards (hereinafter referred to as EPC) designated by dashed lines connected to the upper surface of the glass substrate 21, and further connected to an external control circuit not shown. In the drawing, the upper surface of the glass substrate 22 has little margin and therefore a part of the width of each EPC 26 is overlapped with an adjoining liquid crystal shutter.

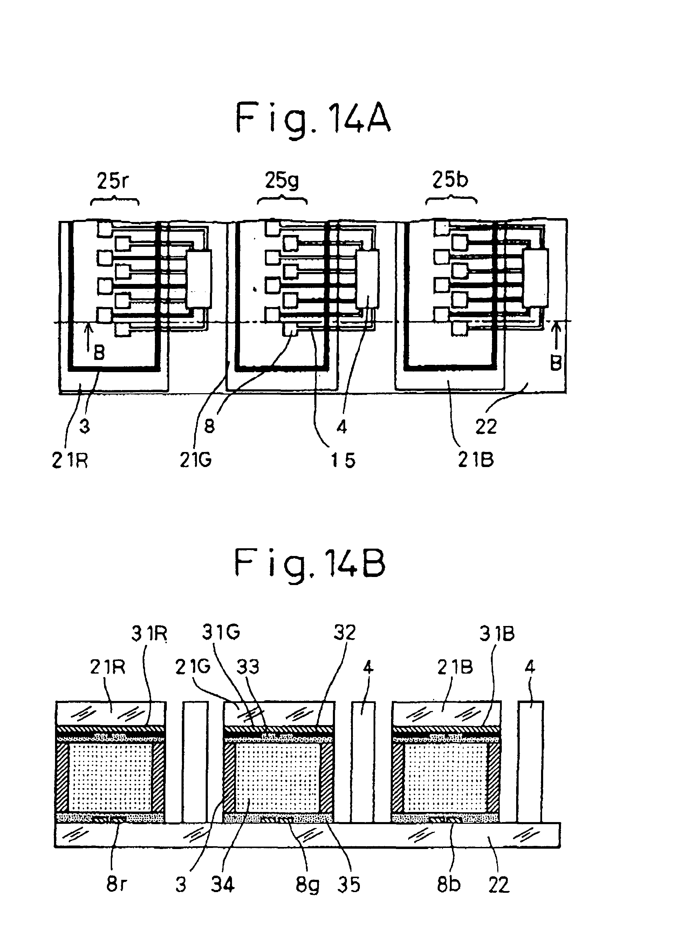

Fig. 14A is a partly enlarged view showing the lower portion of the liquid crystal shutter 420 in Fig. 13, and Fig. 14B is a sectional view taken in line B-B in Fig. 14A. In the liquid crystal shutter 420 according to the fifth embodiment, the cell electrodes 8 are led out by the lead electrodes 15 to one end of each opposed substrate 21R, 21G, 21B of the shutter rows 25r, 25g, 25b of R, G, B, and connected to IC drive circuits 4 each at a point outside the opposed substrates 21R, 21G, 21B, As shown in Fig, 13, a multiplicity of the drive circuits 4 are arranged along the length of the opposed substrates 21R, 21G, 21B, and the lead electrodes 15 are connected distributively to the drive circuits 4. Each drive circuit 4 is connected to a control circuit arranged outside the grass substrate 22 by the EPC 26.

The structure of the three independent liquid crystal shutters for the respective colors is basically the same as shown in Fig. 14B. The polarizers are not shown in Fig. 14B. Also, the masking layer 32, the orientation films 33, 35, etc. have a similar structure to those explained in Fig. 12 and, therefore, are not described any further.

The drive circuits 4 may not be mounted on the glass substrate 22, but each lead electrode 15 may be led to an external control circuit using the EPC 26 on the glass substrate 22. The structure in which the drive circuits 4 are mounted on the glass substrate 22 as in this embodiment, however, can reduce the number of signal lines connected to the control circuit through the EPC 26. As is apparent from Figs. 13 to 14B, according to the fifth embodiment, the lead electrodes 15 connected to the cell electrodes 8 of a given primary color cell row are connected to the drive circuits 4 before reaching the adjoining primary color cell rows and, therefore, are not passed through the cell electrodes 8 of the other primary colors. As a result, as explained with reference to Fig. 12, the motion of the liquid crystal molecules facing the lead electrodes 15 has no effect on the position of the liquid crystal molecules facing the cell electrodes 8 of the other primary colors, thereby making it possible to prevent the color irregularities.

In view of the fact that the cell electrodes 8 are arranged in staggered fashion in each cell row as shown in Fig. 14A, a lead electrode 15 leaving a cell electrode 8 in one row unavoidably passes between the cell electrodes 8 of the other row. However, the cell electrodes 8 of different primary colors are not involved, but only the adjoining cell electrodes 8 of the same primary color. Therefore, the drive voltage difference is so small that the effect of the lead electrode 15 poses no problem. Also, according to the fifth embodiment, the lead electrodes 15 are led out rightward of the shutter rows 25r, 25g, 25b. Nevertheless, the direction in which the lead electrodes 15 are led out is not limited but may be changed as required.

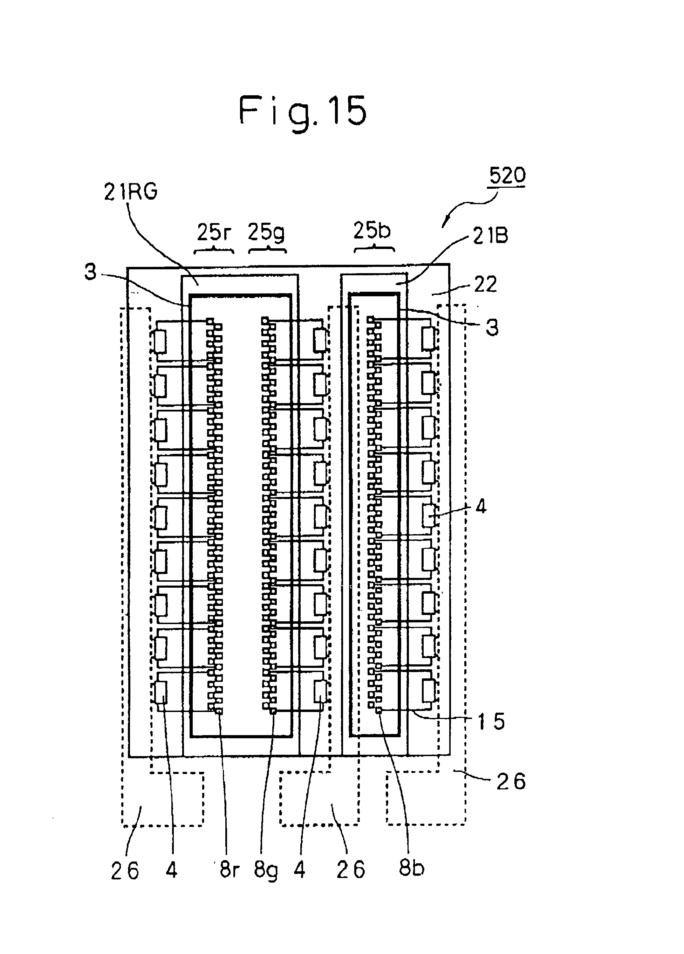

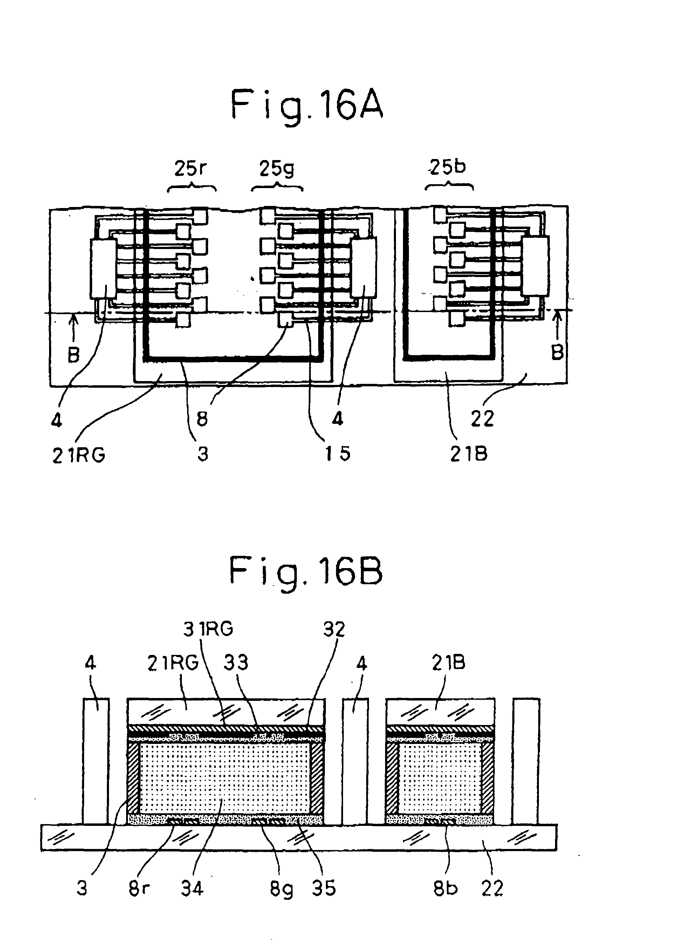

Next, the configuration of the liquid crystal shutter 520 according to a sixth embodiment of the invention will be explained with reference to Figs. 15 to 16B. Fig. 15 is a plan view of the liquid crystal shutter 520, Fig. 16A a partly enlarged view of the lower part of the liquid crystal shutter shown in Fig. 15, and Fig. 16B a sectional view taken in line B-B in Fig. 16A.

According to the fifth embodiment, the substrates 21R, 21G, 21B are arranged each in opposed relation with the shutter rows 25r, 25g, 25b of R, G, B, respectively, on the glass substrate 22. According to the sixth embodiment, on the other hand, one substrate 21RG is arranged in opposed relation with the shutter rows 25r, 25g of R, G, and another one substrate 21B is arranged in opposed relation with the shutter row 25b of B on the glass substrate 22. Specifically, as in the fifth embodiment, only the opposed substrate 21B has the shutter row 25b, while the opposed substrate 21RG accommodates the two shutter rows 25r, 25g of R, G. As a result, the lead electrodes 15 connecting to the R shutter row 25r and the G shutter row 25g are connected to the drive circuits 4 arranged on both sides of the opposed substrate 21RG.

The other structural members of the sixth embodiment are substantially the same as the corresponding structural members of the fifth embodiment, and therefore, though being designated by the same reference numerals, respectively, will not be described. In the sixth embodiment, as compared with the fifth embodiment, the number of the opposed substrates is reduced, and therefore the number of parts is reduced for a smaller number of steps of liquid crystal injection and sealing. According to the fifth embodiment, the configuration with three liquid crystal liquid shutters of the same size can secure an equal interval between the adjoining ones of the three cell rows. In the sixth embodiment, in contrast, the distance between the cell rows is different. However, this point can be incorporated into the design system to avoid a functional problem.

According to the fifth and sixth embodiments so configured that two or three opposed substrates are arranged for each shutter row on a single glass substrate (in the sixth embodiment, two adjoining ones of three shutter rows share an opposed substrate), the dimensions and the positional accuracy between the shutter rows are determined by a single glass substrate, and therefore, a very high accuracy is achieved. At the same time, the liquid crystal shutters can be configured independently for each opposed substrate, and therefore mutual interference, which might otherwise occur when they are driven, can be avoided, thereby making possible a superior shutter operation.

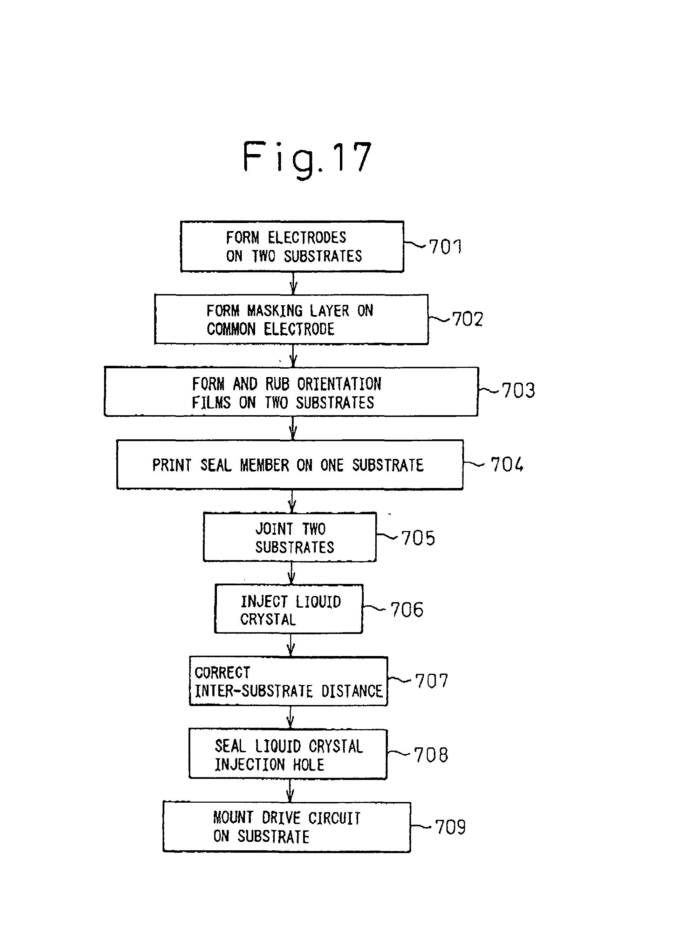

Fig. 17 shows an example of the steps of fabricating a liquid crystal shutter according to the fifth and sixth embodiments of the invention.

In step 701, three sets of the cell electrode 8, the lead electrode 15, an external electrode (not shown), etc. corresponding to the three primary colors R, G, B are formed on the glass substrate 22. The cell electrodes 8 are each 85 µm x 85 µm in size and 0.2 µm thick and are arranged in staggered fashion. Depending on whether the fifth embodiment or the sixth embodiment is involved, a set of three opposed substrates 21R, 21G, 21B or a set of two opposed substrates 21RG, 21B are prepared, and a common electrode is formed over the entire surface of them. The electrode material of ITO is employed for all of them.

In step 702, a masking layer 32 of chromium (Cr) is formed on the common electrode 31 of the opposed substrates 21R, 21G, 21B or the opposed substrates 21RG, 21B. The masking layer 32 is formed only in the areas other than the parts in opposed relation with the cell electrodes 8 on the glass substrate 22.

In step 703, polyimide (PI) is coated by printing on the inner surface of the glass substrate 22, the opposed substrates 21R, 21G, 21B or the opposed substrates 21RG, 21B, and thermally set to form an orientation film. After setting, they are rubbed.

In step 704, a seal portion 3 is screen-printed on the glass substrate 22, or the orientation films 33, 35 of the opposed substrates 21R, 21G, 21B or the opposed substrates 21RG, 21B using the epoxy resin mixed with beads spacers.

In step 705, the glass substrate 22 and the three or two opposed substrates are set in position to each other and jointed by heating under pressure (two hours at 150°C).

In step 706, the 270°-twisted STN liquid crystal is injected from the liquid crystal injection hole.

In step 707, the jointed glass substrate 22, the opposed substrates 21R, 21G, 21B or the opposed substrates 21RG, 21B are pressed to correct the gap (inter-substrate distance), i.e. the layer thickness of the liquid crystal 34 to 5 µm.

In step 708, the liquid crystal injection hole of each liquid crystal shutter is sealed with UV-cured resin.

In step 709, a drive circuit 4 is mounted on the glass substrate 22 along the opposed substrates 21R, 21G, 21B or the opposed substrates 21RG, 21B, i.e. along the length of each independent liquid crystal shutter.

By following the foregoing steps, a high-performance liquid crystal shutter with a simple structure free of color irregularities can be realized.

### INDUSTRIAL APPLICABILITY

With the liquid crystal shutter for the exposure device according to this invention, even in the case where the shutter rows of the respective colors with the passive liquid crystal cells arranged in staggered fashion are interposed in spaced relation with each other to configure a liquid crystal shutter, the upper and lower transparent substrates develop no warping and the optical characteristics of the shutter are not deteriorated. In addition, the shutter operation is not hampered by the interference between the shutter rows due to an electric field. For this reason, a liquid crystal shutter having superior optical characteristics can be fabricated reliably at low cost.

## Claims

1. A liquid crystal shutter comprising a plurality of exposure cells formed as a plurality of shutter rows on a transparent substrate and built in an exposure device for controlling the exposure of a photosensitive medium,
**characterized in that** each of said shutter rows is configured of two rows of a plurality of cells arranged in optically staggered fashion,
said plurality of cells being arranged in such a manner that the relation Q = NP holds, where Q is the pitch of said shutter rows, P is the pitch of said two cell rows, and N is a positive integer larger than 2.

2. A liquid crystal shutter for the exposure device as set forth in claim 1, comprising a transparent common electrode, a plurality of transparent cell electrodes formed on two transparent substrates, respectively, sandwiching the liquid crystal, and a plurality of lead electrodes for leading out said transparent cell electrodes.

3. A liquid crystal shutter for the exposure device as set forth in claim 1,
wherein said plurality of shutter rows is three shutter rows corresponding to red, green and blue, respectively,
wherein said lead electrodes connected to said transparent cell electrodes of said two shutter rows are led out to the two ends of each of said transparent substrates, and
wherein said lead electrodes connected to said transparent cell electrodes of the central shutter row are divided into those led to one end of said transparent substrate and those led to the other end thereof.

4. A liquid crystal shutter for the exposure device as set forth in claim 3, wherein said lead electrodes connected to said transparent cell electrodes of said central shutter row are each led out through the space between said transparent cell electrodes of said two shutter rows arranged on both sides of said central shutter row.

5. A liquid crystal shutter for the exposure device as set forth in claim 1, wherein a partitioning wall for defining the interval between said two transparent substrates is formed between the adjoining ones of said plurality of the shutter rows.

6. A liquid crystal shutter for the exposure device as set forth in claim 5, wherein the pitch Q of said shutter rows is set longer than the distance equal to the sum of the width of said partitioning wall and twice the width of the fringe formed by said partitioning wall.

7. A liquid crystal shutter for the exposure device as set forth in claim 6, wherein the width of said fringe is not less than 2 mm.

8. A liquid crystal shutter for the exposure device as set forth in claim 1, wherein said plurality of cells is so configured that said liquid crystal is held between a transparent common substrate formed with a transparent cell electrode and a lead electrode for leading out said transparent cell electrode and a plurality of transparent opposed substrates formed with a transparent common electrode corresponding to each of said shutter rows.

9. A liquid crystal shutter for the exposure device as set forth in claim 8,
wherein said plurality of shutter rows is three shutter rows corresponding to red, green and blue, respectively, and
wherein said plurality of the transparent opposed substrates formed with said transparent common electrode are three transparent opposed substrates corresponding to said three shutter rows, respectively.

10. A liquid crystal shutter for the exposure device as set forth in claim 8,
wherein said plurality of shutter rows is three shutter rows corresponding to red, green and blue, respectively, and
wherein said plurality of the transparent opposed substrates formed with said transparent common electrode include two transparent opposed substrates, one corresponding to two adjoining ones of said three shutter rows and the other corresponding to the other one shutter row.

11. A liquid crystal shutter for the exposure device as set forth in any one of claims 8 to 10,
wherein said liquid crystal held between said plurality of the transparent opposed substrates and said transparent common substrate is sealed by a seal member for each of said transparent opposed substrates.

12. A liquid crystal shutter for the exposure device as set forth in claim 5, wherein said value N is 46.
